(19) Europäisches Patentamt
European Patent Office
Office européen des brevets

(11) **EP 2 140 974 B1**

(12) **EUROPEAN PATENT SPECIFICATION**

(45) Date of publication and mention
of the grant of the patent:
**21.03.2012 Bulletin 2012/12**

(51) Int Cl.:
*B24D 3/02* $^{(2006.01)}$     *B24D 3/00* $^{(2006.01)}$
*B24D 3/28* $^{(2006.01)}$     *H01L 21/304* $^{(2006.01)}$

(21) Application number: **08751823.9**

(22) Date of filing: **25.03.2008**

(86) International application number:
**PCT/JP2008/056279**

(87) International publication number:
**WO 2008/117883 (02.10.2008 Gazette 2008/40)**

(54) **SYNTHETIC GRINDSTONE**

SYNTHETISCHER SCHLEIFSTEIN

MEULE SYNTHÉTIQUE

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **26.03.2007 JP 2007079244**

(43) Date of publication of application:
**06.01.2010 Bulletin 2010/01**

(73) Proprietors:
• **Tokyo Diamond Tools Mfg.co., Ltd.
Meguro-ku
Tokyo 152-0031 (JP)**
• **Toyota Motor Corporation
Toyota-shi, Aichi 471-8572 (JP)**

(72) Inventors:
• **YOSHIDA, Yuji
Tokyo 152-0031 (JP)**
• **EDA, Hiroshi
Kasama-shi
Ibaraki 309-1738 (JP)**
• **ZHOU, Libo
Hitachinaka-shi
Ibaraki 312-0001 (JP)**

• **KENMOCHI, Masaaki
Tokyo 152-0031 (JP)**
• **TASHIRO, Yoshiaki
Tokyo 152-0031 (JP)**
• **KAMIYA, Sumio
Toyota-shi
Aichi 471-8572 (JP)**
• **IWASE, Hisao
Toyota-shi
Aichi 471-8572 (JP)**
• **YAMASHITA, Teruki
Toyota-shi
Aichi 471-8572 (JP)**
• **OTAKE, Noboru
Toyota-shi
Aichi 471-8572 (JP)**

(74) Representative: **Jackson, Martin Peter
J.A. Kemp & Co.
14 South Square
Gray's Inn
London WC1R 5JJ (GB)**

(56) References cited:
JP-A- 55 094 981     JP-A- 2002 103 238
JP-A- 2002 355 763     JP-A- 2003 172 839
JP-A- 2004 261 942     JP-A- 2005 186 246

## Description

FIELD OF THE INVENTION

The present invention relates to a synthetic grinding stone, as for example known from document JP 2002-103238A, that grinds the surface of a silicon wafer produced from silicon single crystal, especially a bare silicon wafer or a device wafer by means of fixed abrasive grains in place of a series of polishing process using a conventional polishing pad. This synthetic grinding stone can be also applied to a grinding process of a back surface of silicon wafer on the surface of which single or multi layered integrated circuit is formed by device wiring.

DESCRIPTION OF THE PRIOR ART

Generally, a series of surface processing of silicon wafer that is a substrate of semiconductor device, namely, a bare wafer including a device wafer is performed as follows. That is, a bare wafer produced by slicing an ingot of silicon single crystal is processed by several steps e.g. a lapping process, an etching process, a pre-polishing process and a polishing process so as to obtain mirror finished surface. At a lapping process, dimensional accuracy of a wafer such as parallelism or flatness and form accuracy of a wafer are obtained, and in a etching process, work damaged layer caused at the lapping process is removed, further, in a pre-polishing process and a polishing process, mirror finished surface is performed maintaining good form accuracy. In general, said pre-polishing and polishing process are performed using a polishing pad by dropping liquid of polishing compound containing slurry of abrasive grains. This polishing compound contains acid component or basic component, and the processes are advanced by chemical action of acid or base (corrosive action to silicon wafer) and mechanical action by fine particles of abrasive grains contained in the polishing compound.

Above mentioned method is generally performed by performing pre-polishing process using, for example, a sheet of rigid polyurethane foam, then by polishing process using, for example, a polishing pad composed of suede-type synthetic leather. A workpiece such as silicon wafer is pressed against a platen, to which above mentioned sheet or pad are adhered, and both platen and workpiece are rotated with constant supply of liquid of polishing compound containing slurry of fine particles of abrasive grains, and chemical mechanical polishing is performed. Machining mechanism of these pre-polishing and polishing processes are different from that of lapping process, which is a previous process to these polishing processes and uses hard and loose abrasive grains such as fine particles of alumina. For example, chemical action of acidic component or basic component, which are components contained in solution of polishing compound, concretely corrosive (erosive) action of said components to a workpiece such as silicon wafer is used. That is, by corrosive action of acid or alkali, thin and soft eroded layer is formed on the surface of a workpiece such as silicon wafer. Said chemically weakened thin layer is removed by mechanical chemical action of fine particles of abrasive grains, thus machining of a workpiece is proceeded. In ordinary grinding process, it is essential to use harder abrasive grains than a workpiece, however, in a case of chemical mechanical polishing, it is not necessary to use harder abrasive grains than a workpiece, therefore this polishing method can be said as a machining whose load to a workpiece is very low.

In general, a liquid of polishing compound containing colloidal silica as a main abrasive component and further containing acid or base (for example, patent document 1) can be used, further, a liquid of polishing compound that uses another abrasive grains such as cerium oxide together with colloidal silica (for example, patent document 2) can be also used. In these methods, polishing is performed by pressing a workpiece to a flexible sheet or a polishing pad by high pressure and rotating them in wet condition so as to rub the surface of a workpiece. Accordingly, these methods have problems in dimensional accuracy, form accuracy, continuation of effect and stability, which are caused by use of flexible sheet or polishing pad, and problem of roll off phenomenon at outermost periphery part of workpiece after polishing process can not be avoided.

Further, these said methods have also following problem, that is, along with the change of surface condition of a polishing pad caused by loading or damage, machining rate changes by time lapse, therefore, technical difficulty for performing quantitative machining by routine work is high. Furthermore, specific problems caused by use of slurry, that is, contamination of a workpiece after polished, contamination of a polishing machine and environmental pollution by wasted liquid can not be avoided, accordingly, establishment of a washing process, shortening of maintenance cycle of polishing machine and enlargement of loads to wasted liquid treatment facility are pointed out as problems.

To avoid these problems, and from a view point that a conventional method that uses polishing pad, which has a problem in dimensional stability, can not meet requirements to obtain more precise surface roughness, form accuracy and dimensional accuracy in nano meter level, a method to use a synthetic grinding stone as a machining mean is proposed in Patent Document 3. Generally, term of "synthetic grinding stone" indicates an article prepared by bonding fine particles of abrasive grains by bonding material and particles of abrasive grains are fixed in structure of grinding stone. As an abrasive grains, any kind of abrasive grains used ordinary can be used, and as a bonding materials, any kind of compounds that has ability to fix abrasive grains can be use, however, in general, metal, rubber, ceramics or resin can be preferably used.

In above mentioned Patent Document, a grinding stone prepared by fixing abrasive grains having strong grinding forth such as diamond abrasive grains by metal bond or hard resin bond is used, and mirror finishing is tried using an infeed type precision grinding machine having high transcribe ability. Since this type of grinding machine does not use polishing pad, which has problems in dimensional stability and form stability, it is possible to suppress factors to cause problem of form accuracy such as roll off at outermost periphery part of work. Further, since abrasives act in a condition that the abrasive grains are fixed in structure of grinding stone, namely, act as fixed abrasive grains, this method is closer to theoretical accuracy, and has advantage that aimed surface roughness can be more easily performed than the method that uses loose abrasive grains.

Further, said method is not only effective to solve problems regarding surface roughness, dimensional or form stability such as roll off, but also effective to shorten numbers of processes including previous processes to polishing process, and has possibility to perform through process of silicon wafer machining. However, this method has a problem that geometrical scratches specified to fixed abrasive grains caused by use of fixed abrasives are drawn on surface of a workpiece and the scratches become latent defect, further has a problem of fine chipping. Therefore, said method can not be said as a perfect method. Especially, when diamond abrasive grains, which is excellent in grinding force, is use, above mentioned tendency becomes remarkable. Furthermore, in a case when change of form or dimension of the grinding stone itself by alternation of factors of environment such as temperature, humidity or pressure is remarkable, it is unavoidable that the problems of surface roughness, dimensional or form stability are remaining.

Still further, in Patent Document 4, a specific synthetic grinding stone (CM grinding stone) for chemical mechanical grinding is proposed. That is, said grinding stone is characterized to contain a component, which indicates acidity or alkaline feature when dissolved in water, in the grinding stone as a rigid component previously and to form specific pH environment at actual use in wet condition. In said Patent Document, it is indicated that the use of abrasive grains whose hardness is lower than that of diamond abrasive grains is effective, in particular, it is disclosed that the use of cerium oxide as an abrasive grains gives good results. Although this grinding stone provides good grinding effect, has problems in consistency and static and dynamic stability of grinding stone structure itself, and is required to improve characteristics of grinding stone, because deformation and ware of the grinding stone at actual is large and setting up of grinding condition is slightly difficult. And in actual use, said grinding stone is not sufficient to perform mirror finishing on large diameter silicon wafer of 300 mm $\phi$. A synthetic grinding stone using high purified cerium oxide of as an abrasive grains is proposed in Patent Document 5 or Patent Document 6. However, in a case of Patent Document 5, an object to be polished is restricted to amorphous glass alone, further, since wear of the synthetic grinding stone is high and grinding ratio of the grinding stone is very low, the grinding stone is not suited for grinding of silicon wafer composed of silicon single crystal. Further, in a case of Patent Document 6, an object to be polished is restricted to thin film of silicon oxide ($SiO_2$) film formed on a silicon wafer, and since the purpose of the synthetic grinding stone is to obtain uniform surface by very small removing volume, the grinding stone can not be applied for polishing of large removing volume such as surface polishing of a bare silicon wafer or back surface grinding of a device wafer.

Furthermore, in Patent Document 7, surface machining of a workpiece using cerium oxide grinding stone is disclosed. This document relates to a grinding method by use of a grinding stone containing cerium oxide as abrasive grains, however, component and structure of the grinding stone and grinding function of the grinding stone are not disclosed clearly, further, purity of cerium oxide and effect of it are not disclosed clearly. And, regarding kinds of fillers or additives and effects of them are not specifically recited.

Further, a technique to use cluster diamond whose surface is graphitized as a component of abrasive grains is disclosed (for example, Patent Document 8), and in Patent Document 9 a metal bond grinding stone that uses graphite as a solid lubricant is mentioned. These are arts that apply lubricity of graphite, which graphite originally has, to grinding action and aiming improvement of smoothness of grinding action.

As a grinding machine that loads these grinding stone and performs surface machining by infeed motion or by pressure control motion, a machine disclosed in Patent Document 10 can be mentioned.

Patent Document 1: U.S. Patent 3,328,141
Patent Document 2: U.S. Patent 5,264,010
Patent Document 3: JP 2001-328065 publication
Patent Document 4: JP 2002-355763 publication
Patent Document 5: JP 2000-317842 publication
Patent Document 6: JP 2001-205565 publication
Patent Document 7: JP 2005-136227 publication
Patent Document 8: JP 2005-186246 publication
Patent Document 9: JP 2002-066928 publication
Patent Document 10: JP 2006-281412 publication

## DISCLOSURE OF THE INVENTION

The inventors of the present invention earnestly investigated about above mentioned prior arts and accomplished the present invention and the object of the present invention is to provide a grinding stone that can perform surface polishing and planarization of a silicon wafer, a semiconductor element manufactured from silicon wafer, especially, a bare wafer effectively in condition of no strain (no work damaged layer, no residual stress) and no silicon atom defect.

That is, the inventors of the present invention have found that a grinding stone characterized that change in ability and function are small and is excellent in grinding effect can be obtained by use of fine particles of high purified cerium oxide ($CeO_2$) as an abrasive, resin as a bonding materials, salts as a filler and nano-diamond (ultra fine diamond of nano meter size) as an additive, as main components of the synthetic grinding stone. By performing machining on a silicon wafer using the synthetic grinding stone of above mentioned construction, potential of Si atom bond existing in machining range can be weakened in a moment of the machining and at the moment -O-Si-O- can be swept away selectively by lower pressure. Thereby, the inventors of the present invention have found that a grinding stone which is excellent in homogeneity, form stability against heat or pressure, heat resistance, pressure resistance, conductivity and transmitting ability of grinding temperature, further, deformation of the grinding stone, friction and wear at actual use are even and relatively small, furthermore, characterized that change of ability and function is small and is excellent in grinding effect, can be obtained by use of nano diamond as an additives. In particular, the inventors have found that purity of cerium oxide contributes to improvement of grinding force of a synthetic grinding stone and to prevention of cause of defects such as scratches. Further, the inventors have found that selection of kinds and amount of nano-diamond, which is additive, contributes to improvement of dimensional and form stability of the synthetic grinding stone against heat or pressure, improvement of vibration absorbing ability by dynamic vibration of abrasive (m), damping (c) and spring (k) and improvement of grinding force by reduction of numbers of grinding factors.

Salts to be added as a filler weaken potential of Si atom bond in a moment; ps (pico second order), and obtain an effect of removing function by scratching action. And, nano-diamond to be added as an additive has an effect to remove -O-Si-O- selectively by lower pressure by lubrication and radiation of heat. In the present invention, the term of nano-diamond indicates cluster diamond, perfectly graphitizated product of cluster diamond and cluster diamond whose surface part is partially graphitized (graphite cluster diamond: GCD).

Recently, purity of cerium oxide of a product that is dealt with as a cerium oxide compound is indicated by weight % of rare earth oxide (TRO) to whole part and by weight% of cerium oxide contained in rare earth oxide ($CeO_2$/TRO), and these two values are often mentioned together with. And in the present invention, when these two values are mentioned together with, purity of cerium oxide is indicated by the product of these two values. For example, when weight% of TRO is 90% and weight% of $CeO_2$/TRO is 50%, purity of cerium oxide is $(90 \times 50)/100 = 45$ weight%.

Above mentioned object of the present invention is accomplished by a synthetic grinding stone of claim 1 comprising, fine particles of cerium oxide as an abrasive, resin as a bonding materials, salts as a filler and fine particles of graphite cluster diamond as an additive, and these components are main components of the synthetic grinding stone, wherein, purity of cerium oxide is 60 weight% or more, contents of salts contained as a filler is in the range from 1% or more to less than 20% by volume% to whole structure and contents of fine particles of graphite cluster diamond as an additive is in range from 0.1% or more to less than 20% by volume% to whole structure.

## BRIEF ILLUSTRATION OF DRAWSINGS

   Fig.1 is TEM observation picture of surface of silicon wafer ground by grinding stone of Example 3 and electron beam diffraction of it (right lower part).
   Fig.2 is TEM observation picture of surface of silicon wafer polished by chemical mechanical polishing and electron beam diffraction of it (right lower part).

## PREFERRED EMBODIMENT OF THE INVENTION

The first important point of the present invention is to use cerium oxide of high-purity grade whose cerium oxide contents is 60 weight% or more as an abrasive grains. Generally, cerium oxide mined as bastnaesite ore contains large amount of impurities such as other rare earth elements or hafnium and removal of these impurities is difficult, therefore, cerium oxide of 40 to 60 weight% purity is used as a cerium oxide abrasive grains. The inventors of the present invention earnestly investigated about grade of cerium oxide abrasive grains to be used in the synthetic grinding stone of the present invention, and found that defects such as scratches on the surface of a workpiece when ordinary low purity cerium oxide, which is used for polishing of glass, is used as an abrasive grains, can be prevented by use of high purity grade cerium oxide as an abrasive grains, further, the time for process is same or shorter than that of ordinary chemical mechanical polishing of a bare wafer. That is, when purity of fine particles of cerium oxide used as an abrasive grains becomes higher than 60 weight%, a vivid chemical reaction environment is formed between $SiO_2$ molecule, Si atom and $CeO_2$, and found out that in $Si-O_2$ and $Ce-O_2$, $Ce^{3+}$ ion acts to $Si-O_2$ and forms $Si-CeO_2$ in a moment. For example, when GCD of 50-300Ais added by 0.1-20% to the synthetic grinding stone, physical, chemical features of

$$CeO_2-Na_2CO_3-GCD-CaCO_3-bonding\ material$$

such as heat conductivity, affinity and vibration damping are improved and stabilized. Consequently, thermal stoppage near abrasive grain is protected, and weakening of bonding potential of abrasive $CeO_2-SiO_2$ causes at grinding temperature of 150-250 ˚C under lower pressure machining environment in a moment of 0.5ps-1ps. Said radical weakening phenomenon of $CeO_2-SiO_2$ can be explained as follows. That is, under dry condition at 150-250˚C atmosphere, bonding potential $\phi$) (r) (r: interatomic distance) of $S_{SiO2}-O_{SiO2}$ closes to zero, and abrasive grain scratches the surface. This change takes place at a moment in a case of $CeO_2$, while, in a case $SiO_2$, the change takes place very slowly and continuously. Consequently, Si is formed on the surface. In the machining process using the synthetic grinding stone of the present invention, when chemically active machining environment is formed without using grinding fluid, perfect surface characterized that there is no natural oxidized film ($SiO_2$), no strain in Si atom lattice, further, no residual stress can be obtained.

Said effect becomes more remarkable by use of cerium oxide whose purity is 60 weight% or more, and by use of cerium oxide whose purity is 90 weight% or more, very remarkable effect can be obtained. That is, lattices are lined up with constant distance, and this phenomenon can be observed by electron beam diffraction picture. The synthetic grinding stone of the present invention can be accomplished by use of fine particles of high purity cerium oxide whose content of cerium oxide is 60 weight% or more. More desirable purity of cerium oxide is 95 weight% or more, and use of cerium oxide whose cerium oxide purity is 99 weight% or more has no problem in efficiency, however, has problem in economical competitiveness.

A desirable content of cerium oxide in the present invention is from 15 to 70% by volume to whole structure of the grinding stone. When the content is smaller than 15%, effect as abrasive grains is not sufficient and when excesses 70%, excess cutting edges of abrasive grains participation and re-regulation of thermal gripping forth of bonding material+filler+additive and abrasive grains by optimum chemical reaction take place and re-set up of optimum machining condition is caused. Further, the grinding stone becomes structurally brittle and is not desirable from a view point of fracture toughness.

The reason why very high machining accuracy can be obtained by use of fine particles of high purity cerium oxide is illustrated as follows. That is, high purity cerium oxide abrasive of less than approximately 3 $\mu$ m is an aggregate of ultra fine particles of less than approximately 5 nano meter. While, silicon wafer is a single crystal of silicon, and silicon atoms are regularly arranged by tetrahedral structure of diamond structure. In machining process, when radical degree of machining point is raised and vibration of crystal lattice atom is enhanced, silicon is thermally stimulated and amplitude becomes larger by addition of thermal lattice vibration, then potential $\phi$ (r) between atoms drops. When said condition is formed, atoms layer of silica is removed by machining force of ultra fine particles of cerium oxide, which is brought by effect of increase of space density from $Ce^{3+}$ to $Ce^{4+}$ ion and thermal activity of $SiO_2$ molecule formed by mutual reaction of $Si-CeO_2$. That is, since lattice sliding takes place to (111) direction and layers are peeled off gradually, very precise machining accuracy can be obtained. This effect can be obtained by setting a machining point to a specific machining condition, concretely, to activated thermal machining condition of from 80˚C to 300˚C, desirably from 150˚C to 250˚C.

Further, the second important point of the present invention is to use resin, desirably thermosetting resin as a bonding material that grips and bonds fine particles of cerium oxide abrasive in structure of grinding stone stably. Cured product of thermosetting resin is prepared by heat setting of the resin and cured irreversibly by heat. And the cured resin is characterized by not dimensionally changes against thermal change, environmental change of use (physical feature change or dimensional change by humidity or temperature), solvents (dissolving, swelling, shrinking, plasticizing, softening) or time lapse. Therefore, when the resin is used as a bonding material of grinding stone, the resin contributes to form stability and dimensional stability of grinding stone. Above mentioned functions, that is, thermal stability, weather resistance or solvent resistance are indispensable functions and are important points for a synthetic grinding stones that needs precise form accuracy and dimensional accuracy by nano meter level. For stabilizing these functions, it is necessary to complete curing reaction of a thermosetting resin to be used perfectly. Namely, a synthetic grinding stone that curing reaction is still progressing during actual use as a grinding stone must be avoided. Curing reaction of a thermosetting resin to be used is progressed by thermosetting reaction of precursor or pre-polymer of the thermosetting resin, and for the purpose to complete the curing reaction during manufacturing process of the grinding stone, it is necessary to perform heat treatment at curing temperature of the thermosetting resin or slightly higher temperature than the curing temperature for sufficient heat treatment time, and use of a curing (crosslinking) catalyst is also effective.

In the present invention, as a thermosetting resin to be used as a bonding materials, at least one thermosetting resin selected from the group consisting of phenol resins, epoxy resins, melamine resins, rigid urethane resins, urea resins, unsaturated polyester resins, alkyd resins, polyimide resins, polyvinylacetal resins are desirably used, however, from the view point of thermal stability or toughness (fracture toughness $K_I$, $K_{II}$, $K_{III}$), most desirable thermosetting resin among above mentioned thermosetting resins is phenol resin (bakelite resin). These resins can be uncured precursor of pre-polymer at the manufacturing process of a grinding stone, however, after manufacturing process, curing by heat must be completed in obtained product. That is, after synthetic grinding stone is manufactured, physical features such as hardness or form must not be changed by heat or other conditions. In the present invention, together use of a curing (crosslinking) catalyst for above mentioned thermosetting resin is effective for the improvement of form stability.

In the present invention, term of resin volume percentage indicates contents of resin and is indicated by volume contents to whole structure.

The third important point of the present invention is to add salts, especially metal salts as a filler.

Machining efficiency of a synthetic grinding stone of the present invention is depends on machining pressure at grinding process. By elevating machining pressure, problems of burn mark at machining surface or scratches often take place. Said problems can be remarkably solved by adding metal salt as a filler. As a metal salt, inorganic salt consisting of inorganic acid and inorganic base is desirably used. And as a desirable example, sodium carbonate ($Na_2CO_3$), potassium carbonate ($K_2CO_3$), calcium carbonate ($CaCO_3$), water glass (sodium silicate: $Na_2SiO_3$) or sodium sulfate ($Na_2SO_4$) can be mentioned, however, not intending to be limited to these salts. By performing said composition, a synthetic grinding stone that can endure to high machining pressure can be obtained. That is, in a case of a synthetic grinding stone that uses thermosetting resin alone as a bonding material, upper limit of machining pressure to be loaded to the grinding stone is approximately 0.05MPa, and when exceed this upper limit, burn mark takes place and becomes difficult to continue machining process. By using metal salt as a filler, upper limit can be improved to approximately 0.12MPa. And, when grinding process is made by 0.05MPa machining pressure, a synthetic grinding stone containing metal salt as a filler gives good machining efficiency than that of a synthetic grinding stone not containing metal salt.

It is necessary that the amount of metal salt to be added is within the range from 1% or more to less than 20% by volume% to whole structure. When smaller than 1%, effect of metal salt is not sufficient, and when exceed 20%, adding amount is excess and not only gives bad effect to physical properties of grinding stone such as intensity or hardness, but also obstructs function as a bonding materials for grinding stone or effect of GCD. Especially, it is desirable that the amount of metal salt to be added is within the range from 5% or more to less than 18% by volume to whole structure.

The fourth important point of the present invention is to use nano diamond as an additive. Contents of nano diamond is in the range from 0.1% or more to less than 20% by volume% to whole structure. In the synthetic grinding stone of the present invention, as a nano diamond to be added as an additive, graphite cluster diamond (GCD) is desirably used. At a process to produce cluster diamond by explosion reaction, a diamond fine particles having a graphite layer on the surface on it can be obtained as an intermediate. That is, diamond fine particles whose surface is graphitized and core part is diamond, in other words, diamond fine particles whose surface is coated with graphite can be obtained and this intermediate product is called as GCD. Especially, particles of 50A(5nm) to 300 Å (30nm) particle size gives desirable result. By adding prescribed amount of nano diamond, effect to scrape off -O-Si-O- by low grinding pressure can be obtained. Further, by adding GCD to a grinding stone, grinding efficiency does not change, and effective and uniform grinding can be continued continuously. And, by adding GCD to a grinding stone, following effects can be obtained, that is, gripping strength for abrasive are homogenized and become isotropic, isotropic conductivity of grinding heat and heat conductivity are improved, friction and wear are decreased, self dressing ability of abrasive grains is maintained stably, and abrasive vibration damping is improved (approximately 10 times).

The synthetic grinding stone of the present invention is a structural body and can possess pores in the structure. Said pores are existing in a structural body as independent pores or continuous pores, and shape and size are relatively homogeneous. By presence of pores, grinding chips formed during grinding process are caught in the pores and protect accumulation of grinding chips on the surface, further can protect stoppage and storing up of grinding heat. As a method to form pores, a method to blend adequate pore forming agent at production process of grinding stone, or a method to adjust pressing condition at blending process of starting materials and baking process and to form pores can be mentioned. In the present invention, desirable porosity is in the range from 1% or more to less than 30% by volume% to whole structure.

Arranging these static dynamic main factors of grinding stone, Si perfect crystal ground surface characterized that strain of Si atom lattice is closed to zero and there is no structural change such as formation of a natural oxide film $SiO_2$ can be obtained, by performing adequate grinding condition with a synthetic grinding stone and chemically constructing an active field of grinding heat of $CeO_2$-bonding material-pore and silicon wafer. More in detail, machining action as two body contact slide can prove presence of removing ability according to following numerical formula.

$$\text{Intrusion depth of abrasive grain } d = 3/4\,\phi\,(P/2CE)^{2/3}$$

In a case of CM (chemical mechanical) grinding stone, when pressure P (in this condition, 5kpa- 5Mpa), particle size of abrasive grains $\phi$ (2.3 $\mu$m), concentration of abrasive grains C (70%), Young's modulus of Si E (170GPa) are inserted to the numerical formula, mechanical intrusion depth of abrasive grains is approximately 0.01-1nm. In this condition, machining is proceeded by ductile mode. And, since covalent bond force of Si is weakened, $SiO_2$ is removed as to be dredged up. This phenomenon can be explained as follows, that is, thermal stoppage of $CeO_2$ abrasive grains in a synthetics grinding stone is protected, stabilizes weakened radical of bond population (Si-$O_2$ bond potential $\phi$ in molecular dynamics) to $SiO_2$ at grinding temperature of 150-250 °C, and continuation effect can be performed. Said effect can be also based by simulation of grinding heat of molecular dynamics. From results, it is confirmed that removal of Si from several nm to several 100nm by every minute (calculated from change of wafer thickness) is performed not-withstanding of intrusion depth of abrasive grains of CM grinding stone d = 0.01-1nm. As mentioned above, it is obvious that chemical reaction takes part in dry grinding mechanism. For example, $SiO_2$ formed on silicon wafer surface forms silicate by solid-phase reaction with $CeO_2$ abrasive grains as indicated by following chemical reaction formula.

$$2CeO_2 + 2Si\text{-}O\text{-}Si \leftrightarrow 2Si\text{-}O=Ce\text{-}O\text{-}Si+O_2$$

This silicate becomes very soft, and is considered to weaken energy of atomic layer potential $\phi$ (r) at machining surface, therefore, the silicate can be removed easily by an abrasive grains, which is an oxide, even if under dry condition. If thermal stoppage takes place at interface of $CeO_2$ abrasive grains-bonding material (including fillers), excess $SiO_2$ film is firmly formed and a machining layer is formed, however, in a case of synthetic grinding stone of the present invention, a machining layer consisting of $SiO_2$ film is not formed. The important point in above mentioned chemical reaction formula is that high temperature of 200°C or more is necessary to progress the chemical equilibrium to right direction.

To the synthetic grinding stone of the present invention, additives that are added to a conventional grinding stone can be added. Concretely, a filler, a coupling agent, an antioxidant, a coloring agent or a slipping agent can be added if necessary.

In the present invention, a type of grinding machine to which a grinding stone is set and to put in practice grinding process is not particularly restricted. A conventional polishing machine on a platen of which a grinding stone is set instead of polishing pad can be used. Grinding is performed by pressing a workpiece (object to be ground) to the grinding stone by certain pressure and by rotating both workpiece and platen. Further, an ultra-precision grinding machine of so called constant cutting depth processing method can be used. Said ultra-precision grinding machine is characterized that a grinding stone and a workpiece are arranged on same axis so as to face each other, and both the grinding stone and the workpiece are rotated by high speed, and at least one of the grinding stone or the workpiece are moved by very small distance according to previously prescribed cutting depth. Or an ultra-precision grinding machine by constant-pressure processing method that performs grinding of a workpiece can be also used.

Especially, for the purpose to approach aforementioned activated thermal machining condition of from 80°C to 300°C, desirably from 150°C to 250°C, it is desirable to use so called ultra-precision grinding machine of constant-pressure processing or constant cutting depth processing, for example, a machine characterized that a grinding stone and a workpiece are arranged on same axis so as to face each other, and both the grinding stone and the workpiece are rotated by high speed, and at least one of the grinding stone or the workpiece are moved by very small distance according to previously prescribed cutting depth, and is desirable to set up rotating speed and other condition of the machine to specific condition. For example, use of an ultra-precision grinding machine disclosed in Patent Document 10 is desirable. These ultra-precision grinding machines can control grinding temperature by adjusting grinding pressure or relative motion of a grinding stone. In this case, preferable shape of a grinding stone is cup shape or disk shape and both grinding stone and workpiece are rotated by high rotating speed. If these ultra-precision grinding machines are used for machining of a bare wafer, there is an advantage that not only a polishing process but also former processes to the polishing process such as lapping, etching or pre-polishing processes can be performed by same machine as a through process.

A method for manufacturing of the grinding stone is not specifically restricted, and can be manufactured according to a method of ordinary resin bond grinding stone. For example, in a case to use phenolic thermosetting resin as bonding material, a grinding stone can be manufactured by following method. That is, prescribed amount of fine particles of cerium oxide, powder of precursor or pre-polymer of thermosetting phenol resin, filler and additives, which are starting materials, are blended homogeneously and contained in prescribed mold and molded by pressing, then, heat treated by temperature higher than curing temperature of the thermosetting phenol resin. Precursor or pre-polymer of a thermosetting phenol resin can be liquid state, or solution dissolved in solvent. In this case, it is desirable to make the mixture of starting materials paste state. And if necessary, a curing catalyst, a foaming agent or other additives can be added.

For the purpose to process a silicon substrate (single crystal) having $SiO_2$ film on surface skin of silicon semi-conductor to a silicon wafer characterized not to have residual stress, structural change and work damaged layer, combination use of a grinding stone of the present invention with above mentioned ultra-precision grinding machine of horizontal type or vertical type and to operate by practical condition is desirable. For example, when $CeO_2$ is hold by Si-Si bond and GCD, interatomic potential $\phi$ (r) can be shown by following equation,

$$\phi\ (r) = D(\exp\{-2\,\alpha\,(r-r_0)\}\ -\ 2\exp\{-d(r-r_0)\})$$

wherein, r is interatomic distance ($r_0$ is initial position, D is Interatomic potential of material and $\alpha$ is material constant ($A^{-1}$) In a case of $\phi$ (r) = 0 ev, interatomic distance of Si-Si atom r≒2.2 Å, interatomic distance of Si-C (GCD) atom r≒1.8Å, and interatomic force F(r) = 0 means that by addition of GCD, Si atom layer is scraped off by layer by layer orderly without cutting function because Si-Si atom r≒2.2Å and Si-C atom r≒2.0 Å. This simulation result can be verified by manifestation [(Si(001)] of lattice spacing of 3.94Å(theoretical value is 3.84 A).

The synthetic grinding stone of the present invention constructs combination of

grinding stone + $SiO_2$-Si

in optimum containing % of
$CeO_2$-GCD-bonding material-filler-additive-pores.
When grinding is performed by machining condition (machining pressure is 1MPa and relative speed is 15m/s), reaction of $(CeO_2)^-$ and $(SiO_2)^{2+}$ generates grinding temperature of 150-250°C. Then thermochemistry reaction of

$$Si + O_2 \rightarrow (SiO_2)^{2+} + 2e^- \rightarrow SiO_2$$

takes place between abrasive grains, $SiO_2$ and Si at interface. Reduction of numbers of Si bond electron before and after reaction indicates weakening of Si covalent bonding strength, therefore, in this reaction, oxygen is consumed and $e^-$ is released. Accordingly, chemical reaction of

$$2(CeO_2) + 2e^- \longleftrightarrow 2(CeO_2)^- \longleftrightarrow CeO_3 + 1/2O^-$$

progresses toward right direction. Further, intermediate products $(CeO_2)^-$ and $(SiO_2)^{2+}$ in above mentioned two formula react and form a composite product (Ce-O-Si).

$$(SiO_2)^{2+} + 2(CeO_2)^- \longleftrightarrow Ce_2O_3 \cdot SiO_2$$

This composite product is an amorphous product whose bonding strength is very weak. Micro strength of Si (100) single crystal is 11-13GPa, while hardness of $CeO_2$ is about half (5-7GPa). Therefore, it is difficult to remove Si by $CeO_2$. Accordingly, in CM grinding stone machining, since cutting function does not work, work damage layer is not formed. That is, this condition possesses [Xe] $4f^15d^16s^2$ atomic sequence of Ce. Consequently, grinding condition of a rigid grinding stone in which two kinds of oxide of $CeO_2$ and $Ce_2O_3$ are existing depending on whether ionic valency is Ce(III)/$Ce^{3+}$ or Ce(IV)/$Ce^{4+}$ and combining condition of starting materials of CM grinding stone, perform machining of 300mm $\phi$ diameter silicon wafer not to have work damage layer by provision of optimum machining atmosphere (grinding temperature 150-250°C).
The present invention will be illustrated more in detail according to Examples and Comparative Examples, however, not intending to limit the scope of claims of the present invention to the Examples.

EXAMPLES AND COMPARATIVE EXAMPLES

Synthesis of Grinding Stones

As an abrasive grain, fine particles of cerium oxide whose average particle size is 1-3 $\mu$ m is used. As a bonding material, thermosetting phenol resin powder, as a filler, sodium carbonate, as an additive, graphite cluster diamond whose particle size is approximately 100 Å are used. These four components are mixed together homogeneously and poured into prescribed mold and heated and pressed. Grinding stones of Examples 1-4 and Comparative Examples 1-4 of $5.2 \times 10 \times 40$mm size are obtained. Baking conditions at grinding stone molding are mentioned below.

Temperature-programmed, room temperature→80°C: 10minutes
Maintained at 80°C: 5minutes
Pressed and temperature-programmed 80°C→100°C: 10minutes

Temperature-programmed 100˚C→190˚C: 15minutes
Maintained at 190˚C: 18hours
Cooled down to room temperature: 30minutes

$CeO_2$ purity of fine particles of cerium oxide used as an abrasive grains in Examples 1-3, 5 and in Comparative Example1-3 and 5 is 96.5 weight%, $CeO_2$ purity of fine particles of cerium oxide used as an abrasive grains in Example 4 is 65.8 weight% and $CeO_2$ purity of fine particles of cerium oxide used as an abrasive grains in Comparative Example 4 is 42.5 weight%. Abrasive grains volume percentage, resin volume percentage, filler-volume percentage, additives volume percentage and porosity of grinding stones of Examples 1-5 and Comparative Examples 1-5 are shown in Table 1.

Table 1

| | abrasive volume percentage vol% | resin volume percentage vol% | filler volume percentage vol% | additives volume percentage vol% | porocity vol% |
|---|---|---|---|---|---|
| Example 1 | 19.4 | 69.8 | 7.5 | 0.3 | 3.0 |
| Example 2 | 58.4 | 35.1 | 3.6 | 0.3 | 2.6 |
| Example 3 | 38.5 | 43.3 | 13.7 | 0.8 | 3.7 |
| Example 4 | 38.1 | 43.6 | 14.0 | 0.5 | 3.2 |
| Example 5 | 39.0 | 43.7 | 10.0 | 5.0 | 2.3 |
| Comparative Example 1 | 25.2 | 14.7 | 15.1 | - | 45.0 |
| Comparative Example 2 | 38.8 | 58.1 | 0 | - | 3.1 |
| Comparative Example 3 | 39.1 | 29.3 | 29.2 | 0.1 | 2.3 |
| Comparative Example 4 | 37.3 | 43.7 | 14.1 | 0.1 | 4.8 |
| Comparative Example 5 | 53.8 | 44.1 | - | - | 2.2 |

Grinding Test 1 by Synthesized Grinding Stones

Above mentioned grinding stones are equipped to a horizontal ultra-precision grinding machine and grinding tests of silicon bare wafer (3 inches diameter) are made. The purpose of this Grinding Test 1 is to investigate each grinding stones only qualitatively, therefore detailed evaluations are not made in this test.

Grinding condition; rotating speed of grinding stone is 500rpm, rotating speed of workpiece (wafer) is 50rpm, grinding pressure is 0.1 kgf/cm$^2$ and grinding liquid is not used. In evaluation items, "form stability of grinding stone" means degree of displacement by change of external forth or by change of temperature and "transformation and wear of grinding stone" means transformation of shape and wear of grinding stone at actual grinding operation.

Qulitative evaluation results are summarized in Table 2, and evaluation standard in Table 2 are mentioned as follows.

◎: very good O: good
∆: not so good ✕ : bad

Table 2

| | surface roughness | work damaged layer | machining efficiency | scratches | form stability of grinding stone | deformation and wear of grinding stone |
|---|---|---|---|---|---|---|
| Example 1 | ○ | ◎ | ○ | ◎ | ○ | ◎ |
| Example 2 | ○ | ◎ | ◎ | ◎ | ○ | ◎ |

(continued)

| | surface roughness | work damaged layer | machining efficiency | scratches | form stability of grinding stone | deformation and wear of grinding stone |
|---|---|---|---|---|---|---|
| Example 3 | ◎ | ◎ | ◎ | ◎ | ◎ | ◎ |
| Example 4 | ◎ | ◎ | ○ | ○ | ◎ | ◎ |
| Example 5 | ◎ | ◎ | ◎ | ◎ | ◎ | ◎ |
| Comparative Example 1 | ◎ | ◎ | ◎ | ◎ | Δ | x |
| Comparative Example 2 | ◎ | ◎ | ◎ | ◎ | Δ | ○ |
| Comparative Example 3 | ○ | Δ | ◎ | Δ | ◎ | ◎ |
| Comparative Example 4 | ○ | Δ | ◎ | × | ◎ | ◎ |
| Comparative Example 5 | ○ | Δ | ○ | Δ | ◎ | Δ |

Grinding Test 2 by Synthesized Grinding Stones

Grinding stone of Example 5, by which the most excellent results are obtained, and grinding stone of Comparative Example 5 that uses cerium oxide whose $CeO_2$ purity is less than 60 weight% are selected. And grinding tests are made on a bare silicon wafer of 300mm $\phi$ diameter whose surface is primarily ground by a diamond grinding stone of #800 grain size (prescribed by JIS R 6001). Surface roughness of silicon wafer after primary grinding is 13.30nm. Grinding condition; rotating speed of grinding stone is 500rpm, rotating speed of workpiece (wafer) is 50rpm, grinding pressure is 0.1 kgf/cm² and grinding liquid is not used. Evaluation results of ground surface are summarized in Table 3.
For reference, evaluation results of following two specimens are mentioned in Table 3. That is, a specimen prepared by grinding a bare silicon wafer of after primary grinding by same process as mentioned above with a diamond grinding stone of #5000 grain size by grinding condition of rotating speed of the grinding stone is 1500rpm, rotating speed of a workpiece (wafer) is 50rpm, infeed speed is 10 $\mu$ m/min and using water grinding liquid, and a specimen of polished silicon wafer polished by conventional polishing method. In this test, etching is made by using mixed acid of hydrofluoric acid : nitric acid : acetic acid = 9 : 19 : 2 at room temperature for 30 minutes. And, surface roughness is measured by a phase interferometer (New View 200) of ZYGO Co., Ltd. Other evaluations for appearance are visual observation by an inspector.

Table 3

| | | by grinding stone of example 5 | by grinding stone of comparative example 5 | by grinding stone of #5000 diamond | by chemical mechanical polishing |
|---|---|---|---|---|---|
| surface roughness nm | Ra | 0.95 | 1.30 | 3.18 | 0.76 |
| | Ry | 6.20 | 9.26 | 20.05 | 5.22 |
| appearance of machining surface | | homogeneous mirror finished surface | shallow scratches are irregularly formed | regular scratches are observed | homogeneous mirror finished surface |
| surface after etched | | etch pit is not observed | striped etch pits are observed | many striped etch pits are observed | etch pit is not observed |

As clearly understand from the results mentioned in Table 3, surface roughness and appearance of a wafer ground by the grinding stone of the present invention (Example 5) are almost same as to that of the wafer obtained by conventional chemical mechanical polishing method, and regular scratches, which are observed in a wafer ground by a diamond grinding stone, are not observed. Ground surface is etched by mixed acid and the etched surface is inspected. On the surface of the silicon wafer ground by the grinding stone of the present invention, no etch pit is observed and is almost same as to that of the wafer obtained by conventional chemical mechanical polishing method, however, on the surface of the silicon wafer ground by the diamond grinding stone many striped etch pits are observed. Further, depth by etching is also same as to that of the wafer obtained by a conventional chemical mechanical polishing method. From the results shown in Tables 2 and 3, it is obviously understood that the graphite cluster diamond added as an additive contributes to improvement of lubricity of grinding stone, releasing ability of abrasive grains (self dressing ability of abrasive grains), smoothing ability of fine cutting edge of $CeO_2$ (has single crystal structure of fine particles of approximately 50nm or more to average particle size of 1-3 $\mu$ m), lightening of thermal stoppage to bonding material and damping of vibration of abrasive grains, bonding material and at the interface of abrasive grains and bonding material, accordingly, the graphite cluster diamond is essential factor to generate grinding force of abrasive grains. Further, in a case of the grinding stone of Comparative Example 4, which uses cerium oxide whose purity is less than 60 weight%, only a few shallow scratches are formed irregularly and can not be actually used.

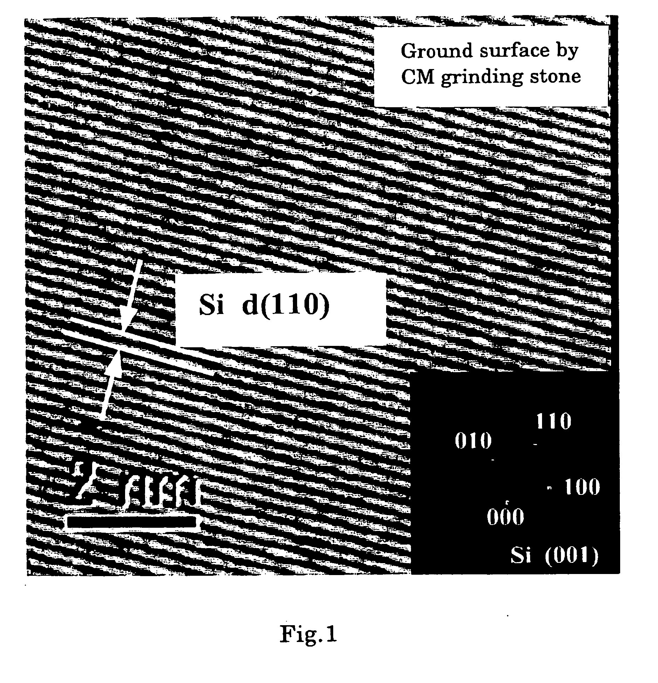

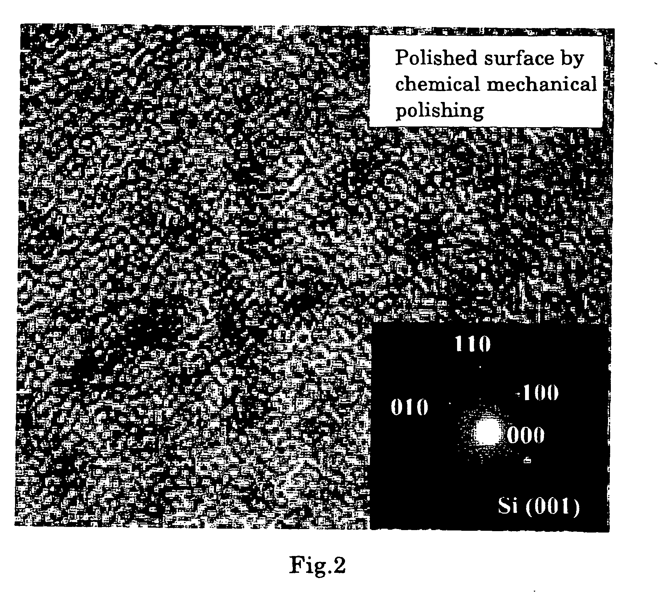

Fig.1 is a TEM (Transmission Electron Microscope) observation picture of surface of silicon wafer ground by grinding stone of Example 3 and electron beam diffraction of it and Fig.2 is a TEM observation picture of surface of silicon wafer polished by conventional polishing method (chemical mechanical polishing method) and electron beam diffraction of it. As clearly understood from these Figs, on surface of the silicon wafer ground by dry state grinding using the grinding stone of the present invention, lattice structure of Si single crystal can be observed, on the contrary, on finished surface of the silicon wafer polished by conventional chemical mechanical polishing method, lattice structure can not be observed because amorphous $SiO_2$ layer exists on the surface. That is, in dry state grinding using a synthetic CM grinding stone, lattice image of Si (001) face is in-line coordinated and maintain normal atomic lattice distance, however, in final polished (chemical mechanical polishing method) surface, said lattice image can not be observed. Further, in a case of synthetic grinding stone of the present invention, atomic lattice diffraction of Si (001) face shows diffraction image at prescribed diffraction site and angle, however, in a case of final polished surface by conventional polishing method, halo appears and n-pattern, which indicates formation of amorphous $SiO_2$ is recognized. In a machining layer by the CM grinding stone, there is no defect such as cracking, plastic strain or dislocation. Therefore, machining with no machining layer can be obtained by the CM grinding stone.

3.5nm $\times$ 7nm region is measured on 300mm $\phi$ silicon wafer obtained by the synthesized grinding stone of the present invention, using TEM observation (observed by 400Kv, 800000 magnification) and an atomic force prove microscope (product of Asylum Research Inc., MFP-30), and result that Si single crystal atomic lattice (011) face distance is 3.94Ais obtained, and this result is almost meets with theoretical space wave length 3.84Å. This result shows 0.1Å lattice strain, and means that so called residual strain is almost zero. In TEM observation image (ground surface by CM grinding stone) of Fig.1, each lattice face are clearly observed, accordingly, it is understood that Si single crystal structure is formed from the surface. Therefore, by use of synthetic grinding stone of the present invention, machining of 300mm $\phi$ silicon wafer without machining layer and having silicon single crystal structure as it is can be accomplished.

In the synthetic grinding stone for silicone wafer grinding of the present invention, reaction of ($CeO_2$) and $(SiO_2)^{2+}$ is proceeded during grinding process in constitution composed of,

$$\textbf{abrasive grains} + \textbf{bonding material} + \textbf{filler} + \textbf{additive}$$

and composite product indicated by $Ce_2O_3 \cdot SiO_2$ is formed on the surface. This composite product is an amorphous compound whose bonding strength is very weak. This composite product can be easily removed by a grinding stone designed so as $CeO_2$ abrasive grains to have optimum grinding removing ability, that is, performing optimum machining condition (use of machining temperature of 150-250˚C) by combination of,

$$CeO_2 + GCD + \text{bonding material} + \text{filler} + \text{additive},$$

optimum conditions of blending ratio and grinding condition. Accordingly, a silicon wafer without machining layer can be obtained by use of high purified cerium oxide fine particles, not using cutting function of abrasive grains by applying an evolved machining theory, which can overcome ultra-precision grinding machine by constant-pressure processing method, that is, can overcome mechanical accuracy.

INDUSTRIAL APPLICABILITY

As mentioned above, according to the grinding stone of the present invention, polishing of silicon wafer (chemical mechanical polishing) using conventional polishing pad and polishing compound (slurry) can be replaced by synthetic CM grinding stone possessing fixed abrasive grains. That is, by use of CM grinding stone machining using synthetic grinding stone, not only problems of form accuracy such as roll off, which as polished silicon wafer polished by conventional chemical mechanical polishing method has, can be dissolved, but also problems caused by use of polishing pad and polishing compound containing secondary deficiency can be dissolved. In other words, dissolving of problems regarding instability of machining accuracy in continuous use, pollution of machines and circumstance caused by use of loose abrasive grains, pollution of a workpiece itself and environmental pollution by wasted liquid becomes possible. Further, by the grinding stone of the present invention, it becomes possible to perform a throughout continuous process from as cut wafer to final polishing by not using machining liquid, accordingly, machining cost by a conventional method that uses large amount of expensive loose abrasive grains or slurry can be reduced. That is, the grinding stone of the present invention is very effective for silicon wafer machining, and can contribute largely to a semiconductor field.

## Claims

1. A synthetic grinding stone comprising, fine particles of cerium oxide as abrasive grains, resin as bonding material, salts as filler and fine particles of graphite cluster diamond as an additive, and these components are main components of the synthetic grinding stone, wherein, purity of cerium oxide is 60 weight% or more, contents of salts contained as filler is in the range from 1% or more to less than 20% by volume% to the whole structure and contents of fine particles of graphite cluster diamond as additive is in the range from 0.1 % or more to less than 20% by volume% to the whole structure.

2. The synthetic grinding stone of claim 1, wherein resin as bonding material is at least one thermosetting resin selected from the group consisting of phenol resins, epoxy resins, melamine resins, rigid urethane resins, urea resins, unsaturated polyester resins, alkyd resins, polyimide resins, polyvinylacetal resins.

3. The synthetic grinding stone of claim 1 or claim 2, wherein salts as filler is a metal salt consisting of inorganic acid and inorganic base

4. The synthetic grinding stone according to anyone of claims 1 to 3, wherein the particle size of the graphite cluster diamond is from 50 angstrom(Å) to 300Å.

## Patentansprüche

1. Synthetischer Schleifstein, der feine Partikel von Ceroxid als Schleifkörner, Harz als Bindematerial, Salze als Füllstoff und feine Partikel von Graphit-Clusterdiamant als Additiv umfasst, wobei diese Komponenten Hauptkomponenten des synthetischen Schleifsteins sind, wobei die Reinheit von Ceroxid 60 Gew.-% oder mehr ist, die Gehalte an Salzen, die als Füllstoff enthalten sind, im Bereich von 1 Vol.-% oder mehr bis weniger als 20 Vol.-%, bezogen auf die gesamte Struktur, sind und die Gehalte an feinen Partikeln von Graphit-Clusterdiamant als Additiv im Bereich von 0,1 Vol.-% oder mehr bis weniger als 20 Vol.-%, bezogen auf die gesamte Struktur, sind.

2. Synthetischer Schleifstein gemäß Anspruch 1, wobei Harz als Bindematerial wenigstens ein wärmehärtbares Harz ist, das aus der Gruppe, bestehend aus Phenolharzen, Epoxidharzen, Melaminharzen, starren Urethanharzen, Harnstoffharzen, ungesättigten Polyesterharzen, Alkydharzen, Polyimidharzen, Polyvinylacetalharzen, ausgewählt ist.

3. Synthetischer Schleifstein gemäß Anspruch 1 oder 2, wobei Salze als Füllstoff ein Metallsalz, bestehend aus anorganischer Säure und anorganischer Base, sind.

4. Synthetischer Schleifstein gemäß einem der Ansprüche 1 bis 3, wobei die Partikelgröße des Graphit-Clusterdiamanten 50 Angström (Å) bis 300 Å ist.

## Revendications

1. Pierre d'affûtage synthétique comprenant des particules fines d'oxyde de cérium en tant que grains abrasifs, une résine en tant que matériau de liaison, des sels en tant que charge et des particules fines de diamant à réseau graphitique en tant qu'additif, et ces composants sont les composants principaux de la pierre d'affûtage synthétique dans laquelle la pureté de l'oxyde de cérium est supérieure ou égale à 60 % en poids, la teneur en sels contenus en tant que charge est comprise dans la plage allant de 1 % ou plus à moins de 20 % en volume par rapport à la structure totale et la teneur en particules fines de diamant à réseau graphitique en tant qu'additif est comprise dans la plage allant de 0,1 % ou plus à moins de 20 % en volume par rapport à la structure totale.

2. Pierre d'affûtage synthétique selon la revendication 1, dans laquelle la résine en tant que matériau de liaison est au moins une résine thermodurcissable choisie dans le groupe constitué par les résines phénoliques, les résines époxy, les résines de mélamine, les résines d'uréthane rigides, les résines d'urée, les résines de polyester insaturé, les résines alkydes, les résines polyimides, les résines de polyvinylacétal.

3. Pierre affûtage synthétique selon la revendication 1 ou 2, dans laquelle les sels en tant que charge sont des sels métalliques comprenant un acide inorganique et une base inorganique.

4. Pierre affûtage synthétique selon l'une quelconque des revendications 1 à 3, dans laquelle la taille des particules du diamant à réseau graphitique est de 50 angströms (Å) à 300 Å.

Fig.1

EP 2 140 974 B1

Fig.2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002103238 A
- US 3328141 A
- US 5264010 A
- JP 2001328065 A
- JP 2002355763 A
- JP 2000317842 A
- JP 2001205565 A
- JP 2005136227 A
- JP 2005186246 A
- JP 2002066928 A
- JP 2006281412 A